# EUROPEAN PATENT APPLICATION

(11) **EP 4 693 393 A1**
(43) Date of publication of application: **11.02.2026**
(21) Application number: 24779858.0
(22) Date of filing: 21.03.2024
(51) Int. Cl.: H01L 23/14, H01L 23/36, H05K 1/02

(54) **SUBSTRATE FOR MOUNTING SEMICONDUCTOR ELEMENT**

(30) Priority: 30.03.2023 JP 2023055863
(71) Applicant: Niterra Co., Ltd., Nagoya-shi, Aichi 461-0005 (JP)
(72) Inventor: KONDO, Yosuke, Nagoya-shi, Aichi 461-0005 (JP); MURASE, Tatsunori, Nagoya-shi, Aichi 461-0005 (JP); USAMI, Kenzo, Nagoya-shi, Aichi 461-0005 (JP); NISHIMURA, Mitsuru, Nagoya-shi, Aichi 461-0005 (JP); WATANABE, Yukihiro, Nagoya-shi, Aichi 461-0005 (JP); SANO, Isuzu, Nagoya-shi, Aichi 461-0005 (JP)
(74) Representative: Cabinet Beau de Loménie
(86) International application number: PCT/JP2024/011071
(87) International publication number: WO 2024/203738

(57) **Abstract**

A semiconductor element mounting substrate includes a base composed of a metal, an electrode to be connected to a semiconductor element, and an insulating layer disposed between the base and the electrode, in which a maximum height Sz (micrometers) of a base-side surface of the insulating layer specified by ISO 25178 is equal to or less than the thickness of the layer itself.

## Description

### Technical Field

The present invention relates to a semiconductor element mounting substrate.

### Background Art

There is a known semiconductor element mounting substrate for mounting semiconductor elements. For example, PTL 1 discloses a semiconductor element mounting substrate that includes a base composed of a metal, a wire, and an insulating layer that insulates between the base and the wire.

### Citation List

### Patent Literature

PTL 1: Japanese Unexamined Patent Application Publication No. 7-240570

### Summary of Invention

### Technical Problem

However, even in the prior art such as the one disclosed in PTL 1, there has been some room for improvements regarding the technology for improving the insulating properties in the semiconductor element mounting substrate. Since the semiconductor element mounting substrate disclosed in PTL 1 has a base composed of a metal, it is necessary that the base and the wire be insulated from each other by an insulating layer. However, when the insulating layer is excessively thick, cracks may occur due to the difference in thermal expansion coefficient with respect to the base, and cracks degrade the insulating properties of the insulating layer. On the contrary, when the insulating layer is excessively thin, the insulating layer does not sufficiently cover the base, and short circuiting may occur between the base and the wire.

An object of the present invention is to provide a technology for improving the insulating properties in the semiconductor element mounting substrate.

### Solution to Problem

The present invention has been made to address at least some of the aforementioned issues and can be implemented through the following aspects.

(1) According to an aspect of the present invention, there is provided a semiconductor element mounting substrate. This semiconductor element mounting substrate includes a base composed of a metal, an electrode to be connected to a semiconductor element, and an insulating layer disposed between the base and the electrode, in which a maximum height Sz (micrometers) of a base-side surface of the insulating layer specified by ISO 25178 is equal to or less than the thickness of the layer itself.

According to this feature, the maximum height Sz (micrometers) of the base-side surface of the insulating layer specified by ISO 25178 is equal to or less than the thickness of the layer itself. In this manner, since the insulating layer has a particular thickness or more throughout the entirety, the insulating layer can cover the entire base composed of the metal. Thus, the insulating property can be improved.

(2) In the semiconductor element mounting substrate according to the aforementioned aspect, the insulating layer may have a thickness of 10 micrometers or less. According to this feature, the stress generated due to the difference in thermal expansion coefficient with the base composed of the metal is relatively small, and generation of cracks in the insulating layer can be suppressed. Thus, short-circuiting between the electrode and the base through the cracks is suppressed, and the insulating property can thereby be improved.

(3) In the semiconductor element mounting substrate according to the aforementioned aspect, a maximum height Sz (micrometers) of the base-side surface of the insulating layer specified by ISO 25178 may be 4 micrometers or less. According to this feature, the maximum height Sz (micrometers) of the base-side surface of the insulating layer specified by ISO 25178 is 4 micrometers or less. In this manner, voids are rarely formed between the base-side surface of the insulating layer and the layer facing the base-side surface; thus, cracks starting from the voids are unlikely to be formed in the insulating layer. Thus, the insulating property can be improved.

(4) In the semiconductor element mounting substrate according to the aforementioned aspect, an arithmetical mean height Sa (micrometers) of the base-side surface of the insulating layer specified by ISO 25178 may be 0.4 micrometers or less. According to this feature, the arithmetical mean height Sa (micrometers) of the base-side surface of the insulating layer is 0.4 micrometers or less. In other words, since the base-side surface of the insulating layer is relatively flat, voids are rarely formed between the base-side surface of the insulating layer and the layer facing the base-side surface. In this manner, since cracks starting from the voids are rarely formed in the insulating layer, and thus the insulating property can be improved.

(5) In the semiconductor element mounting substrate according to the aforementioned aspect, an arithmetic mean roughness Ra (micrometers) of the base-side surface of the insulating layer specified by JIS B 0601 may be 0.4 micrometers or less. According to this feature, the arithmetic mean roughness Ra (micrometers) of the base-side surface of the insulating layer is 0.4 micrometers or less. In other words, since the base-side surface of the insulating layer is relatively flat, voids are rarely formed between the base-side surface of the insulating layer and the layer facing the base-side surface. In this manner, since cracks starting from the voids are rarely formed in the insulating layer, and thus the insulating property can be improved.

(6) In the semiconductor element mounting substrate according to the aforementioned aspect, the insulating layer may be formed by using a material that contains, as a main component, one selected from Al₂O₃, SiO₂, Y₂O₃, AlN, Si₃N₄, and SiC. According to this feature, the insulating layer is formed by using a material that contains, as a main component, one selected from Al₂O₃, SiO₂, Y₂O₃, AlN, Si₃N₄, and SiC that have relatively high electrical insulating properties. In this manner, the insulating property of the insulating layer can be improved.

(7) In the semiconductor element mounting substrate according to the aforementioned aspect, the base may be formed by using a material that contains, as a main component, aluminum or copper. According to this feature, the base is formed by using a material that contains, as a main component, copper or aluminum which has a high heat-dissipating property, and thus when the base functions as a heat dissipating substrate that releases the heat generated in the semiconductor element, the heat-dissipating property can be improved.

(8) In the semiconductor element mounting substrate according to the aforementioned aspect, the insulating layer does not have to have cracks that extend from the base-side surface and reach an electrode-side surface. According to this feature, the insulating layer does not have cracks that extend from the base-side surface and reach the electrode-side surface. Thus, short-circuiting between the electrode and the base through the cracks is suppressed, and the insulating property can thereby be improved.

It should be noted that the present invention can be implemented in various forms, for example, a product that includes a semiconductor element mounting substrate, an apparatus that includes a semiconductor package, and methods for producing the semiconductor element mounting substrate and the semiconductor package.

### Brief Description of Drawings

[Fig. 1] Fig. 1 is a schematic cross sectional view of a semiconductor element mounting substrate according to a first embodiment.
[Fig. 2] Fig. 2 is a schematic cross sectional view of a semiconductor package.
[Fig. 3] Fig. 3 is a schematic view of a cross sectional photograph of a semiconductor element mounting substrate according to a comparative example.
[Fig. 4] Fig. 4 is a schematic view of a cross sectional photograph of the semiconductor element mounting substrate according to the first embodiment.
[Fig. 5] Fig. 5 is a diagram illustrating an evaluation test method for a semiconductor element mounting substrate.
[Fig. 6] Fig. 6 is a table indicating the results of the evaluation test for the semiconductor element mounting substrate.

### Description of Embodiments

### <First embodiment>

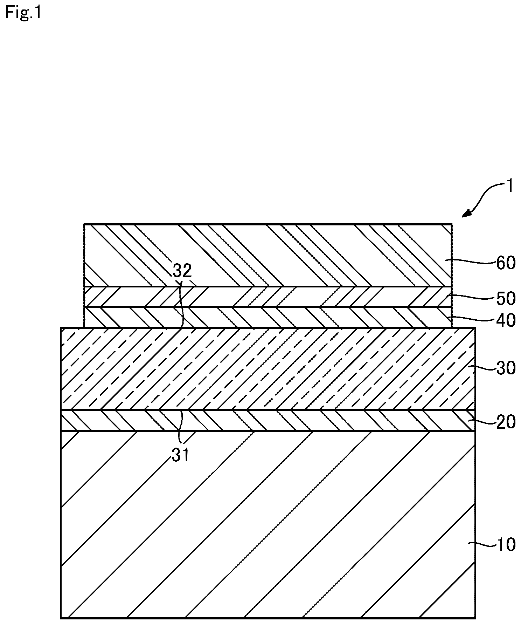

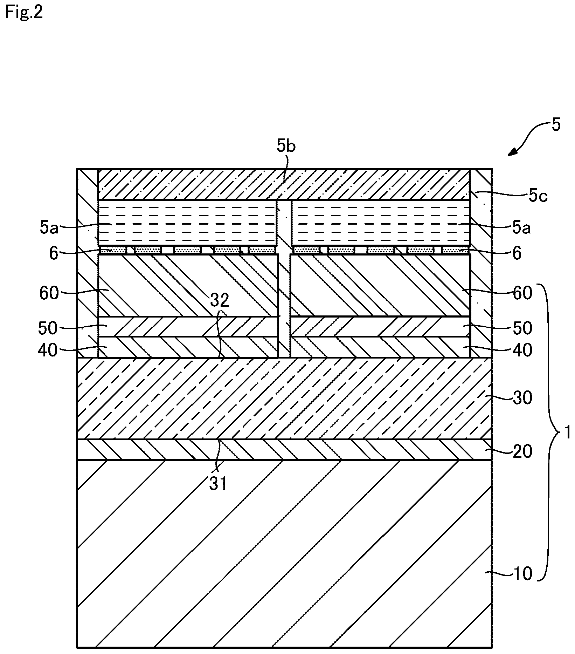

Fig. 1 is a schematic cross sectional view of a semiconductor element mounting substrate 1 according to a first embodiment. Fig. 2 is a schematic cross sectional view of a semiconductor package 5 that includes the semiconductor element mounting substrate 1 according to the first embodiment. The semiconductor element mounting substrate 1 according to this embodiment supports, as a semiconductor element 5a, a photosemiconductor such as a light emitting diode (LED) or a semiconductor laser (laser diode or LD) and functions as a heat-dissipating substrate that releases the heat generated during emission to the exterior. The semiconductor element mounting substrate 1 includes a base 10, an adhesive layer 20, an insulating layer 30, an adhesive layer 40, a joining layer 50, and an electrode 60. It should be noted that, in Figs. 1 and 2, the thickness relationships among the base 10, the adhesive layer 20, the insulating layer 30, the adhesive layer 40, the joining layer 50, the electrode 60, and the semiconductor element 5a are illustrated differently from what they actually are for the sake of convenience.

The base 10 is a flat plate-shaped member and serves as a foundation of the semiconductor element mounting substrate 1. In this embodiment, the base 10 has a thickness of 1 mm. The base 10 is composed of a metal. In this embodiment, the base 10 is composed of copper (Cu). The base 10 may be formed by using a material containing copper as a main component, aluminum (Al), or a material containing aluminum as a main component. Here, the "main component" means a component that accounts for 50% or more of the subject material in terms of mass%. The base 10 may be composed of an alloy of copper and aluminum. When the base 10 is formed by using these metals, the heat generated in the semiconductor element 5a can be efficiently released to the exterior through the base 10.

The adhesive layer 20 is disposed between the base 10 and the insulating layer 30. In this embodiment, the adhesive layer 20 is composed of titanium (Ti) and has a thickness of, for example, 0.5 micrometers. The adhesive layer 20 causes the base 10 and the insulating layer 30 to tightly adhere to each other and also suppresses formation of cracks in the insulating layer 30 caused by the difference in thermal expansion coefficient.

The insulating layer 30 is disposed between the base 10 and the electrode 60, more specifically, between the adhesive layer 20 and the adhesive layer 40. The insulating layer 30 is formed by using a material that contains, as a main component, one selected from Al₂O₃, SiO₂, Y₂O₃, AlN, Si₃N₄, and SiC. The insulating layer 30 in this embodiment is formed by using Al₂O₃, which has a relatively high electrical insulating property. The insulating layer 30 is formed by using a material containing alumina (Al₂O₃) as a main component. In this embodiment, the insulating layer 30 has a thickness of 10 micrometers or less. Here, the thickness of the insulating layer 30 refers to an average thickness within a particular range. The insulating layer 30 insulates between the base 10 and the electrode 60 that are composed of metals. The details of the insulating layer 30 will be described below.

The adhesive layer 40 is disposed between the insulating layer 30 and the joining layer 50. In this embodiment, the adhesive layer 40 is composed of titanium and has a thickness of, for example, 0.2 micrometers. The adhesive layer 40 causes the insulating layer 30 and the joining layer 50 to tightly adhere to each other and also suppresses formation of cracks in the insulating layer 30 caused by the difference in thermal expansion coefficient.

The joining layer 50 is disposed between the adhesive layer 40 and the electrode 60. The joining layer 50 is composed of palladium (Pd) and has a thickness of, for example, 0.07 micrometers. The joining layer 50 improves the joining strength between the adhesive layer 40 and the electrode 60.

The electrode 60 is connected to the semiconductor element 5a via a bump 6 (see Fig. 2). The electrode 60 is composed of gold (Au) and has a thickness of, for example, 3.0 micrometers.

A semiconductor package 5 includes a semiconductor element mounting substrate 1, the semiconductor element 5a, a phosphor 5b, and a resin portion 5c (see Fig. 2). In the semiconductor package 5, the phosphor 5b is disposed on the side opposite to the semiconductor element mounting substrate 1 with respect to the semiconductor element 5a connected to the semiconductor element mounting substrate 1 via the bump 6. The phosphor 5b converts the wavelength of the light emitted from the semiconductor element 5a, which is a photosemiconductor, and emits the changed light to the exterior. The resin portion 5c seals the semiconductor element 5a.

Next, the features of the semiconductor element mounting substrate 1 according to this embodiment are described. The maximum height Sz (micrometers) of a base 10-side surface 31 of the insulating layer 30 in the semiconductor element mounting substrate 1 specified by ISO 25178 is equal to or less than the thickness of the layer itself. In this embodiment, the maximum height Sz (micrometers) of the base 10-side surface 31 of the insulating layer 30 specified by ISO 25178 is 4 micrometers or less. Furthermore, the arithmetical mean height Sa (micrometers) of the base 10-side surface 31 of the insulating layer 30 specified by ISO 25178 is 0.4 micrometers or less, and the arithmetic mean roughness Ra (micrometers) of the base 10-side surface 31 specified by JIS B 0601 is 0.4 micrometers or less. As such, the base 10-side surface 31 of the insulating layer 30 of this embodiment is relatively flat. Each of the maximum height Sz (micrometers), the arithmetical mean height Sa (micrometers), and the arithmetic mean roughness Ra (micrometers) of the surface 31 of the insulating layer 30 can be measured by etching the semiconductor element mounting substrate 1 to expose the base 10-side surface of the insulating layer 30 and performing measurement thereon with a laser microscope.

In the semiconductor element mounting substrate 1 according to this embodiment, the base 10-side surface 31 of the insulating layer 30 is relatively flat. Due to this feature, the insulating layer 30 does not have cracks that extend from the base 10-side surface 31 and reach an electrode 60-side surface 32. The presence or absence of the cracks in the insulating layer 30 can be confirmed by taking a cross sectional SEM image.

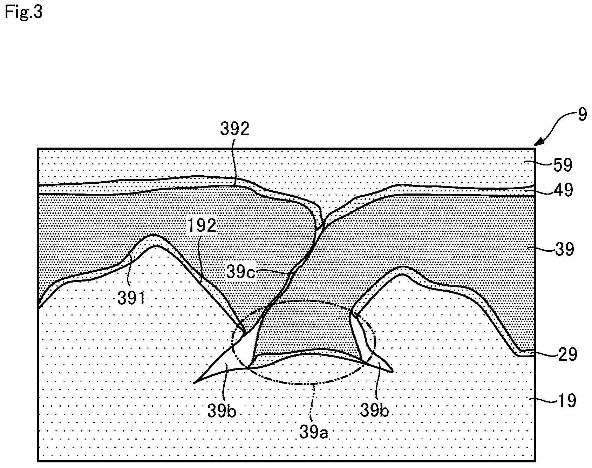

Fig. 3 is a schematic view of a cross sectional photograph of a semiconductor element mounting substrate 9 according to a comparative example. Fig. 3 shows a schematic view of one portion of the cross sectional SEM photograph of the semiconductor element mounting substrate 9 according to the comparative example. As shown in Fig. 3, the semiconductor element mounting substrate 9 of the comparative example includes a base 19, an adhesive layer 29, an insulating layer 39, an adhesive layer 49, a joining layer 59, and an electrode not illustrated in the drawing. The maximum height Sz (micrometers) of a base 19-side surface 391 of the insulating layer 39 in the semiconductor element mounting substrate 9 of the comparative example specified by ISO 25178 is equal to or more than the thickness of the layer itself. In general, a semiconductor element substrate is produced by sequentially stacking an adhesive layer, an insulating layer, etc., on a base; thus, the profile of the base-side surface of the adhesive layer, the insulating layer, or the like may be affected by the profile of the insulating layer-side surface of the base. In the semiconductor element mounting substrate 9 of the comparative example, the insulating layer 39 is formed on the base 19 with a relatively thin adhesive layer 29 therebetween; thus, the maximum height Sz (micrometers) of the base 19-side surface 391 of the insulating layer 39 may be considered to be affected by the profile of the insulating layer 39-side surface 192 of the base 19. When the maximum height Sz (micrometers) of the base 19-side surface 391 of the insulating layer 39 is larger than the thickness of the layer itself as in the semiconductor element mounting substrate 9 of the comparative example, the insulating layer 39 cannot completely cover the insulating layer 38-side surfaces of the adhesive layer 29 and the base 19, and the insulating layer 39 may fail to insulate between the base 19 and the electrode.

Furthermore, as shown in Fig. 3, in the semiconductor element mounting substrate 9 of the comparative example, a reversed taper shape protrusion (portion surrounded by a two-dot chain line 39a in Fig. 3) is formed on the base 19-side surface 391 of the insulating layer 39. Here, the "reversed taper shape" refers to a shape in which the width of the insulating layer 39 increases as the insulating layer 39 comes closer to the base 19. When the base 19-side surface 391 of the insulating layer 39 has a reversed taper shape protrusion 39a, a void 39b is likely to form between the base 19-side surface 391 and the base 19 or the adhesive layer 29. Thus, as shown in Fig. 3, a crack 39c that extends from the base 19-side surface 391 and reaches a joining layer 59-side surface 392 may form from the void 39b as the starting point, and thus short-circuiting between the base 19 and the electrode with the joining layer 59 therebetween may occur.

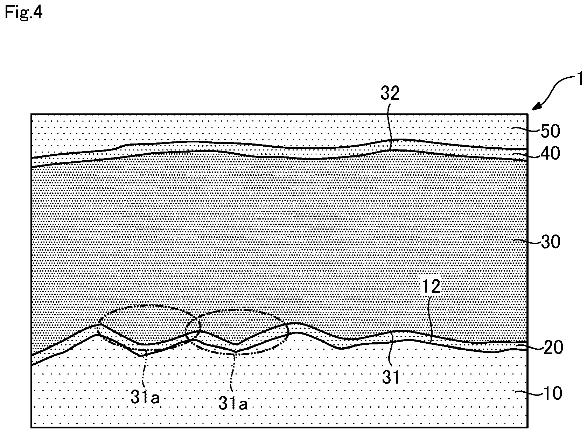

Fig. 4 is a schematic view of a cross sectional photograph of the semiconductor element mounting substrate 1 according to the first embodiment. Fig. 4 shows a schematic view of one portion of the cross sectional SEM photograph of the semiconductor element mounting substrate 1 as in Fig. 3. In the semiconductor element mounting substrate 1, the maximum height Sz (micrometers) of the base 10-side surface 31 of the insulating layer 30 is equal to or less than the thickness of the layer itself although this may depend on the relationship between the profile of the base-side surface of the insulating layer and the profile of the insulating layer-side surface of the base described above. In other words, it can be understood that the insulating layer 30 is capable of covering, with a particular thickness, the entire insulating layer 30-side surface 12 of the base 10 with the adhesive layer 20 therebetween.

Furthermore, as shown in Fig. 4, in the semiconductor element mounting substrate 1 of this embodiment, a taper shape protrusion (portion surrounded by a two-dot chain line 31a in Fig. 4) is formed on the base 10-side surface of the insulating layer 30. Here, the "taper shape" refers to a shape in which the width of the insulating layer 30 decreases as the insulating layer 30 comes closer to the base 10. When the base 10-side surface 31 of the insulating layer 30 has a taper shape protrusion, a void rarely forms between the base 10-side surface 31 and the adhesive layer 20. In other words, the insulating layer 30 does not have cracks that extend from the base 10-side surface 31 and reach the electrode 60-side surface 32. In this manner, occurrence of a crack from a void as a starting point can be suppressed, and short-circuiting between the base 10 and the electrode 60 caused by the crack can thereby be suppressed.

Next, the evaluation test for the semiconductor element mounting substrate is described. In this evaluation test, the relationship between the insulating property of the semiconductor element mounting substrate, the arithmetical mean height Sa (micrometers) specified by ISO 25178, and the arithmetic mean roughness Ra (micrometers) specified by JIS B 0601 was evaluated for the base-side surface of the insulating layer.

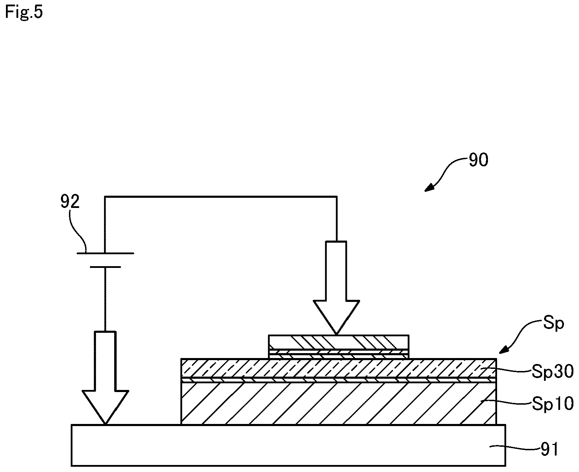

Fig. 5 is a diagram illustrating the evaluation test method for a semiconductor element mounting substrate. In this evaluation test, a resistance tester 90 illustrated in Fig. 5 was used to measure the resistance value of each of the samples of six types of semiconductor element mounting substrates, and the insulating property of each sample was evaluated. Specifically, the resistance of a sample Sp is calculated from the relationship between the current and voltage flowing in the sample Sp when a particular voltage is applied, by using a power supply 92, to the sample Sp placed on an electrically conductive stage 91 with a base Sp10 contacting the stage 91. In this evaluation test, the thickness of an insulating layer Sp30 included in each of the six types of samples was set to 5 micrometers. In this evaluation test, multiple specimens were prepared for each sample, the resistance value of each specimen was measured, and the proportion of the number of specimens that exhibited a predetermined resistance value or more relative to the total number of specimens on which the resistance value was measured was defined as a "pass rate".

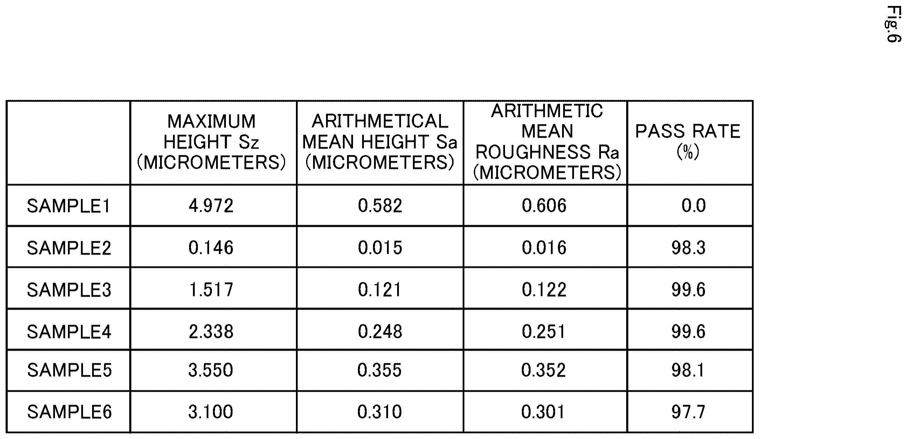

Fig. 6 is a table indicating the results of the evaluation test for the semiconductor element mounting substrate. Fig. 6 indicates, for each of the six types of samples, the maximum height Sz (micrometers) specified by ISO 25178, the arithmetical mean height Sa (micrometers) specified by ISO 25178, and the arithmetic mean roughness Ra (micrometers) specified by JIS B 0601 of the base 10-side surface of the insulating layer Sp30, and the pass rates (%).

Regarding the relationship between the maximum height Sz (micrometers) and the insulating property, as shown in Fig. 6, for a sample 1 that had the highest maximum height Sz (micrometers), i.e., 4.972 micrometers, among the six types of samples, no samples exhibited a resistance value equal to or more than the predetermined resistance value, and the pass rate was 0%. In other words, in the sample 1, all of the specimens exhibited a resistance value lower than the predetermined resistance value, and this indicated that the sample 1 did not have the specified insulating property. Meanwhile, in samples 2 to 6 in which the maximum height Sz (micrometers) is less than 4 micrometers, the pass rate all exceeded 97%, and this indicated that the samples 2 to 6 had the specified insulating property. As such, the semiconductor element mounting substrate exhibits an insulating property when the maximum height Sz (micrometers) of the base-side surface of the insulating layer is 4 micrometers or less.

Regarding the relationship between the arithmetical mean height Sa (micrometers) and the insulating property, as shown in Fig. 6, for a sample 1 that had the highest arithmetical mean height Sa (micrometers), i.e., 0.582 micrometers, among the six types of samples, no samples exhibited a resistance value equal to or more than the predetermined resistance value, and the pass rate was 0%. In other words, in the sample 1, all of the specimens exhibited a resistance value lower than the predetermined resistance value, and this indicated that the sample 1 did not have the specified insulating property. Meanwhile, in samples 2 to 6 in which the arithmetical mean height Sa (micrometers) was less than 0.4 micrometers, the pass rate all exceeded 97%, and this indicated that the samples 2 to 6 had the specified insulating property. As such, the semiconductor element mounting substrate exhibits an insulating property when the arithmetical mean height Sa (micrometers) of the base-side surface of the insulating layer is 0.4 micrometers or less.

Regarding the relationship between the arithmetic mean roughness Ra (micrometers) and the insulating property, as shown in Fig. 6, for the sample 1 that had the highest arithmetic mean roughness Ra (micrometers), i.e., 0.606 micrometers, among the six types of samples, no samples exhibited a resistance value equal to or more than the predetermined resistance value, and the pass rate was 0%. In other words, as described above, in the sample 1, all of the specimens exhibited a resistance value lower than the predetermined resistance value, and the sample 1 did not have the specified insulating property. Meanwhile, in samples 2 to 6 in which the arithmetic mean roughness Ra (micrometers) was less than 0.4 micrometers, the pass rate all exceeded 97%, and this indicated that the samples 2 to 6 had the specified insulating property. As such, the semiconductor element mounting substrate exhibits an insulating property when the arithmetic mean roughness Ra (micrometers) of the base-side surface of the insulating layer is 0.4 micrometers or less.

According to the semiconductor element mounting substrate 1 of this embodiment described heretofore, the maximum height Sz (micrometers) of the base 10-side surface 31 of the insulating layer 30 specified by ISO 25178 is equal to or less than the thickness of the layer itself. In this manner, since the insulating layer 30 has a particular thickness or more throughout the entirety, the insulating layer 30 can cover the entire base 10 composed of a metal. Thus, the insulating property can be improved.

Furthermore, according to the semiconductor element mounting substrate 1 of this embodiment, the thickness of the insulating layer 30 is 10 micrometers or less; thus, the stress generated due to the difference in thermal expansion coefficient with the base 10 composed of copper becomes relatively small. This can also suppress generation of cracks in the insulating layer 30. Thus, short-circuiting between the electrode 60 and the base 10 through the crack is suppressed, and the insulating property can thereby be improved.

According to the semiconductor element mounting substrate 1 of this embodiment, the maximum height Sz (micrometers) of the base 10-side surface 31 of the insulating layer 30 specified by ISO 25178 is 4 micrometers or less. In this manner, voids are rarely formed between the base 10-side surface 31 of the insulating layer 30 and the adhesive layer 20 and/or the base 10; thus, cracks starting from the voids are unlikely to be formed in the insulating layer. Thus, the insulating property can be improved.

According to the semiconductor element mounting substrate 1 of this embodiment, the arithmetical mean height Sa (micrometers) of the base 10-side surface 31 of the insulating layer 30 specified by ISO 25178 is 0.4 m or less. In other words, since the base 10-side surface of the insulating layer 30 is relatively flat, voids are rarely formed between the base 10-side surface of the insulating layer 30 and the layer facing the base 10-side surface. In this manner, since cracks starting from the voids are rarely formed in the insulating layer, and thus the insulating property can be improved.

According to the semiconductor element mounting substrate 1 of this embodiment, the arithmetic mean roughness Ra (micrometers) of the base 10-side surface 31 of the insulating layer 30 specified by JIS B 0601 is 0.4 micrometers or less. In other words, since the base 10-side surface 31 of the insulating layer 30 is relatively flat, voids are rarely formed between the base 10-side surface of the insulating layer 30 and the layer facing the base 10-side surface. In this manner, since cracks starting from the voids are rarely formed in the insulating layer, and thus the insulating property can be improved.

According to the semiconductor element mounting substrate 1 of this embodiment, the insulating layer 30 is formed by using a material containing alumina, which has relatively high electrical insulating property, as a main component. In this manner, the insulating property can be improved.

In addition, according to the semiconductor element mounting substrate 1 of this embodiment, the base 10 is formed by using copper, which has high heat-dissipating property, and thus the heat generated in the semiconductor element 5a can be efficiently released to the exterior.

Furthermore, according to the semiconductor element mounting substrate 1 of this embodiment, the insulating layer 30 has no cracks that extend from the base 10-side surface 31 and reach an electrode 60-side surface 32, as illustrated in Fig. 4. Thus, short-circuiting between the electrode 60 and the base 10 through the cracks is suppressed, and the insulating property can thereby be improved.

### <Modification examples of the present embodiment>

The present invention is not limited to the aforementioned embodiments and can be implemented through various modes without departing from the gist thereof; for example, following modifications are possible.

### [Modification Example 1]

In the embodiment described above, the semiconductor element mounting substrate supports the photosemiconductor and functions as a heat-dissipating substrate that releases heat generated during emission to the exterior. However, the semiconductor to be mounted on the semiconductor element mounting substrate is not limited to the photosemiconductor.

### [Modification Example 2]

In the embodiment described above, the insulating layer 30 has a thickness of 10 micrometers or less. However, the thickness of the insulating layer 30 is not limited to this. When the heat dissipating property of the semiconductor element mounting substrate 1 may be lower due to the operating conditions or the operating environment, the thickness may be, for example, 15 micrometers or less.

### [Modification Example 3]

In the embodiment described above, the maximum height Sz (micrometers) of the base 10-side surface 31 of the insulating layer 30 specified by ISO 25178 is 4 micrometers or less. The maximum height Sz (micrometers) may be larger than 4 micrometers. The smaller the maximum height Sz (micrometers), the less likely that voids would be formed between the base 10-side surface 31 of the insulating layer 30 and the surface of the adhesive layer 20 or the base 10 facing the surface 31.

### [Modification Example 4]

In the embodiment described above, the arithmetical mean height Sa (micrometers) of the base 10-side surface 31 of the insulating layer 30 specified by ISO 25178 is 0.4 micrometers or less. The arithmetical mean height Sa (micrometers) may be larger than 0.4 micrometers. The smaller the arithmetical mean height Sa (micrometers), the less likely that voids would be formed between the base 10-side surface 31 of the insulating layer 30 and the surface of the adhesive layer 20 or the base 10 facing the surface 31.

### [Modification Example 5]

In the embodiment described above, the arithmetic mean roughness Ra (micrometers) of the base 10-side surface 31 of the insulating layer 30 specified by JIS B 0601 is 0.4 micrometers or less. The arithmetic mean roughness Ra (micrometers) may be larger than 0.4 micrometers. The smaller the arithmetic mean roughness Ra (micrometers), the less likely that voids would be formed between the base 10-side surface 31 of the insulating layer 30 and the surface of the adhesive layer 20 or the base 10 facing the surface 31.

Although the present aspect have been described on the basis of the embodiments and the modification examples above, the embodiments of the aspect described above are to facilitate understanding of the aspect and do not limit the aspect. This aspect is subject to modifications and improvements without departing from the gist and the scope of the claims and includes equivalents thereof. Furthermore, any technical feature not described as essential in the present description can be omitted as appropriate.

### (Application Example 1)

A semiconductor element mounting substrate comprising:
a base composed of a metal;
an electrode to be connected to a semiconductor element; and
an insulating layer that is disposed between the base and the electrode, wherein a maximum height Sz (micrometers) of a base-side surface specified by ISO 25178 is equal to or less than the thickness of the layer itself.

### (Application Example 2)

The semiconductor element mounting substrate described in Application Example 1, wherein:
the insulating layer has a thickness of 10 micrometers or less.

### (Application Example 3)

The semiconductor element mounting substrate described in Application Example 1 or 2, wherein:
a maximum height Sz (micrometers) of the base-side surface of the insulating layer specified by ISO 25178 is 4 micrometers or less.

### (Application Example 4)

The semiconductor element mounting substrate described in Application Example 1 or 3, wherein:
an arithmetical mean height Sa (micrometers) of the base-side surface of the insulating layer specified by ISO 25178 is 0.4 micrometers or less.

### (Application Example 5)

The semiconductor element mounting substrate described in Application Example 1 or 4, wherein:
an arithmetic mean roughness Ra (micrometers) of the base-side surface of the insulating layer specified by JIS B 0601 is 0.4 micrometers or less.

### (Application Example 6)

The semiconductor element mounting substrate described in any one of Application Examples 1 to 5, wherein:
the insulating layer is formed by using a material that contains, as a main component, one selected from Al₂O₃, SiO₂, Y₂O₃, AlN, Si₃N₄, and SiC.

### (Application Example 7)

The semiconductor element mounting substrate described in Application Example 1 or 6, wherein:
the base is formed by using a material that contains, as a main component, aluminum or copper.

### (Application Example 8)

The semiconductor element mounting substrate described in any one of Application Examples 1 to 7, wherein:
the insulating layer does not have cracks that extend from the base-side surface and reach an electrode-side surface.

### Reference Signs List

1, 2 semiconductor element mounting substrate
5a semiconductor element
10 base
30 insulating layer
31 base-side surface (of the insulating layer)
32 electrode-side surface (of the insulating layer)
60 electrode

## Claims

1. A semiconductor element mounting substrate comprising:
a base composed of a metal;
an electrode to be connected to a semiconductor element; and
an insulating layer that is disposed between the base and the electrode, wherein a maximum height Sz (micrometers) of a base-side surface specified by ISO 25178 is equal to or less than the thickness of the layer itself.

2. The semiconductor element mounting substrate according to claim 1, wherein:
the insulating layer has a thickness of 10 micrometers or less.

3. The semiconductor element mounting substrate according to claim 1 or 2, wherein:
a maximum height Sz (micrometers) of the base-side surface of the insulating layer specified by ISO 25178 is 4 micrometers or less.

4. The semiconductor element mounting substrate according to claim 3, wherein:
an arithmetical mean height Sa (micrometers) of the base-side surface of the insulating layer specified by ISO 25178 is 0.4 micrometers or less.

5. The semiconductor element mounting substrate according to claim 3, wherein:
an arithmetic mean roughness Ra (micrometers) of the base-side surface of the insulating layer specified by JIS B 0601 is 0.4 micrometers or less.

6. The semiconductor element mounting substrate according to claim 1 or 2, wherein:
the insulating layer is formed by using a material that contains, as a main component, one selected from Al₂O₃, SiO₂, Y₂O₃, AlN, Si₃N₄, and SiC.

7. The semiconductor element mounting substrate according to claim 1 or 2, wherein:
the base is formed by using a material that contains, as a main component, aluminum or copper.

8. The semiconductor element mounting substrate according to claim 1 or 2, wherein:
the insulating layer does not have cracks that extend from the base-side surface and reach an electrode-side surface.
